# EUROPEAN PATENT APPLICATION

(11) **EP 4 262 328 A1**
(43) Date of publication of application: **18.10.2023**
(21) Application number: 23165045.8
(22) Date of filing: 29.03.2023
(51) Int. Cl.: H05K 1/11, H05K 3/42, H05K 3/46, H05K 1/02

(54) **LOADING PADS FOR IMPEDANCE MANAGEMENT IN PRINTED CIRCUIT BOARD**

(30) Priority: 04.04.2022 US 202263327064 P; 06.03.2023 US 202318117805
(71) Applicant: Google LLC, Mountain View, CA 94043 (US)
(72) Inventor: Noujeim, Leesa Marie, Mountain View, CA, 94043 (US); Li, Hongyu, Mountain View, CA, 94043 (US)
(74) Representative: Betten & Resch

(57) **Abstract**

A printed circuit board (PCB) for three-dimensional (3D) packaging that may facilitate packaging multiple electronic components therein is provided. The PCB (100) may include one or more loading pads (153a-e) formed around signal or ground vias (154) to facilitate impedance control and reduce likelihood of signal distortion. The loading pads (153a-e) may be formed on a plane (164, 166, 168, 170, 172) in a body of a dielectric layer (102-110) configured to form the PCB. (100)

## Description

### CROSS-REFERENCE TO RELATED APPLICATIONS

This application claims the benefit of the filing date of U.S. Provisional Patent Application No. 63/327,064, filed April 4, 2022, the disclosure of which is hereby incorporated herein by reference.

### BACKGROUND

Electronic devices, such as tablets, computers, copiers, digital cameras, smart phones, control systems and automated teller machines, among others, often employ electronic components such as chip assemblies or integrated circuit (IC) dies that are connected by various interconnect components. The chip assemblies or IC dies may include memory, logic, devices, or other IC dies.

The demand for IC dies or chip assemblies for higher performance, higher capacity and lower cost has driven the demand for small sizes and more capable microelectronic components. A printed circuit board (PCB) may provide mechanical support for multiple IC dies or chip assemblies mounted onto the PCB. The PCB may include conductive traces to electrically connect devices, components and other electrical structures mounted on the PCB. The PCB may include multiple layers stacked up in a vertical configuration where the conductive traces may be formed on a layer and/or between the layers to electrically connected a conductive trace from a layer to another conductive trace with another layer. Multiple vias, such as ground vias or signal vias, may be utilized to connect among the conductive traces. Different configurations and locational placements of the vias and trace lines may result in different electrical performance of the electrical communications among the electrical devices and components mounted on the PCB. For example, neighboring signal and ground via(s), which form part of the signal transmission paths, often present higher impedance than a desired impedance level. Poor configuration of the via layouts may result in poor electrical performance, such as low signal transmission, high reflections, or high impedance.

### SUMMARY

The present disclosure relates to vias with loading pads formed in layers of a PCB. Such loading pads formed with the vias may facilitate impedance continuity so as to reduce likelihood of signal distortion during transmission. In one example, a printed circuit board (PCB) includes a first dielectric layer. A second dielectric layer is formed on the first dielectric layer, defining a first plane between the first and the second dielectric layers. A first loading pad is formed on the first plane between the first and second dielectric layers. In some examples, the first and second dielectric layers are in direct contact with one another, without a metal plane extending therebetween. In this regard, the only metal between the first and second dielectric layers may be metal that forms the first loading pad. In other examples, a metal plane may extend between the first and second dielectric layers. For example, the metal plane may include a solid metal plane with anti-pad extending around the first loading pad. In other examples, the metal plane may include a signal layer with various metal shapes.

In some examples, a stack may include additional layers of dielectric, wherein some layers are separated by a metal plane and some are not. For example, a first loading pad may be formed on a surface of a first layer of dielectric, and a second layer of dielectric may be formed directly on the surface of the first layer of dielectric. A metal layer may be formed on a surface of the second layer of dielectric. A second loading pad may also be formed on the surface of the second layer of dielectric in an area absent of the metal layer. For example, an anti-pad may be formed in the metal layer around an area where the second loading pad is to be formed. The first and second loading pads may be vertically aligned. A via may extend through the first and second loading pads. Additional layers of dielectric may be formed in vertical alignment with the first and second dielectric layers. In some examples, metal planes may separate alternate dielectric layers, such as by being formed on the second layer, fourth layer, etc.

The metal plane may be, for example, a ground plane, a signal plane, a power plane, etc. The via extending through the loading pads and dielectric layers may be, for example, a signal via or a ground via.

The antipad may include non-conductive materials. The loading pads may be formed from aluminum foil or copper foil or similar materials.

According to some examples, each layer of dielectric may be approximately a same thickness, such that the loading pads between each layer are approximately equidistant from one another. In other examples, the layers of dielectric may have varying thicknesses.

Another aspect of the technology is directed to a three-dimensional integrated circuit (IC) packaging structure having a printed circuit board (PCB). In one example, PCB includes a stack of dielectric layers. Conductive features may be formed on one or more planes between dielectric layers. For example, vertically adjacent dielectric layers may form a plane between the vertically adjacent layers. The plane may include conductive features, or it may exclude conductive features. In some examples, one or more loading pads may be formed on the plane, whether conductive features are included in the plane or not. The one or more loading pads may be vertically aligned. For example, a first loading pad on a first plane between first and second dielectric layers that are in direct contact may be vertically aligned with a second loading pad on a second plane between second and third dielectric layers that are separated by metal. A via may be formed through the loading pads and the stack of dielectric layers.

According to another aspect, a printed circuit board (PCB) for three-dimensional (3D) packaging that may facilitate packaging multiple electronic components therein is provided. The PCB may include one or more loading pads formed around signal or ground vias to facilitate impedance control and reduce likelihood of signal distortion. The loading pads may be formed on a plane in a body of a dielectric layer configured to form the PCB.

In one example, the via may be a signal via or a ground via.

Another aspect of the technology is directed to a method for forming a PCB. In one example, the method includes forming a loading pad between two dielectric layers. A signal via may be formed by penetrating through the loading pad.

### DESCRIPTION OF THE DRAWINGS

FIG. 1 depicts a cross-sectional view of a portion of a PCB having multiple loading pads with a signal via extending therethrough in accordance with aspects of the disclosure.
FIG. 2 depicts a top view of a portion of the PCB 100 cutting along the axis A- A' depicted in FIG. 1 in accordance with aspects of the disclosure.
FIG. 3 depicts a flow chart for manufacturing loading pads formed around the signal vias in accordance with aspects of the disclosure.
FIGS. 4A-4J depicts cross-sectional view of manufacturing the loading pads formed around the signal vias during different manufacturing stages of FIG. 3.
FIG. 5 depicts a perspective view of the loading pads formed around the signal vias in accordance with aspects of the disclosure.

### DETAILED DESCRIPTION

The technology relates generally to a printed circuit board (PCB) that may be utilized for three-dimensional IC packaging technology. The PCB may include one or more loading pads, that extend around signal vias, formed on a plane between dielectric layers. Some of the dielectric layers may be in direct contact with each other such that the only conductive material between the dielectric layers may be the conductive material that forms a loading pad. In some examples, a metal plane, or layer, may extend along the plane between at least some of the dielectric layers. In examples where there is a metal plane between the dielectric layers, the metal plane may be a solid metal plane with an anti-pad extending around the loading pad on the metal plane. The loading pads may be formed on a surface of or on the plane between dielectric layers where the vias are penetrated therethrough. Additionally or alternatively, the loading pads may be formed on a surface of the dielectric layer, where the surface also include a metal plane between the dielectric layers. The loading pads may be vertically aligned, and a via may extend through the vertically aligned loading pads. The via may be, in some examples, a signal via or ground via. The loading pads extending around the signal via may reduce impedance discontinuity and thus reduce the likelihood of signal distortion.

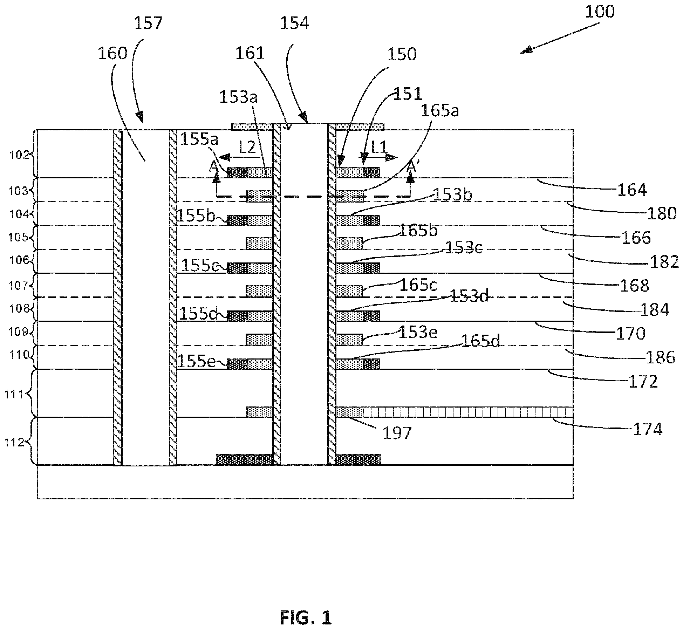

FIG. 1 depicts a cross sectional-view of a portion of a PCB 100 having a plurality of dielectric layers 102-112The plurality of dielectric layers 102-112 may be vertically aligned. According to some examples, the dielectric layers 102-112 may generally be formed with insulating materials.

As shown, each dielectric layer 102-112 includes a top surface and a bottom surface. For example, the bottom surface of the dielectric layer 102 is adjacent to the top surface of dielectric layer 103 while the bottom surface of the dielectric layer 103 is adjacent to the top surface of the dielectric layer 104. The interface between the top surface of one dielectric layer and the bottom surface of an adjacent dielectric layer may form a plane, such as planes 164, 166, 168, 170, 172, 174, 180, 182, 184, 186. Some planes 180, 182, 184, 186 may be the interface of two dielectric layers, such that the dielectric layers are in direct contact with one another. Some planes 164, 166,168, 170, 172 may be formed of a conductive material 150 and extend between two dielectric layers. The conductive material 150 may define planes 164, 166, 168, 170, 172. According to some examples, planes 164, 166 ,168, 170, 172 may include a ground plane 164, 166, 168, 170, 172, a signal plane 174, or other types of the planes, such as a power plane, with desired configurations and purposes. The ground planes 164, 166, 168, 170, 172 and signal plane 174 are represented with solid lines between respective dielectric layers 102-112 while the planes defining the interface between two respective dielectric layers are represented with dashed lines.

The conductive materials 150 may be copper foils, aluminum foils, or other suitable conductive materials that may facilitate forming conductive features with different patterns, different layouts or different configurations in each defined ground plane 164, 166, 168, 170, 172, signal plane 174, power plane, or other planes. In the example depicted in FIG. 1, the conductive material 150 may be patterned to form conductive features 151. According to some examples, the conductive material 150 may be patterned to define a ground plane between adjacent dielectric layers, such as ground plane 164 between dielectric layer 102 and dielectric layer 103.

In the example depicted in FIG. 1, a portion of the conductive material 150 may be patterned to form the conductive features 151, such as loading pads 153a-e. The loading pads 153a-e may be configured to circumscribe around via 154, which may be formed through the dielectric layers 102-112. As the loading pads 153a-e are formed from the conductive features 151, which are copper foils, aluminum foils, or other suitable conductive materials, the loading pads 153a-e are also formed from copper foils, aluminum foils, or other suitable conductive materials.

According to some examples, loading pads 153a-e may be formed on planes between adjacent dielectric layers 102-112. For example, loading pads 153a-e may be formed on respective ground planes 164, 166, 168, 170, 172, signal plane 174, or any other types of the planes. Loading pads 153a-e may include conductive materials, such as copper, aluminum, solder and/or other suitable conductive materials.

In some examples, loading pads 165a-d may be formed on planes between adjacent dielectric layers 102-112. For example, loading pads 165a-d may be formed on a plane between adjacent dielectric layers that are in direct contact with one another, without a metal plane extending therebetween. In such an example, load pads 165a-d is the only conductive material between the respective dielectric layers. As just one example, as shown in Fig. 1, loading pad 165a is formed on the plane 180 between dielectric layer 130 and dielectric layer 104. According to some examples, by forming loading pads 165a-d on a plane 180, 182, 184, 186 between dielectric layers that are in direct contact with one another, parasitic inductance and capacitance effect may be minimized. Further, impedance may be lowered so as to reduce the likelihood of signal distortion.

In one example, the loading pads 153a-e may be integrated with the structure of via 154. The via 154 may be formed by drilling holes in PCB 100, such as with a laser or a mechanical drill. According to some examples, via 154 may be a plated-through hole extending through the stack of dielectric layers. The via 154 may be filled with conductive material 161, such as copper, solder, aluminum, gold, and/or any other suitable conductive materials. The conductive material 161 may be the same conductive materials utilized to form the loading pads 153a-e. Alternatively, the via 154 may be a conductive tube filled with a non-conductive material such as dielectric or air.

The stack of dielectric layers 102-112 may include one or more vias. For example, the stack of dielectric layers 102-112 may include a via 154 and via 157. One of the vias, such as via 154, may be configured as a signal via while another via, such as via 157, may be configured as a ground via. Similar to via 154, via 157 may also include conductive materials 160 filled therein. The via 157 may extend through at least one of the signal planes and may be placed in electrical communication with the electrically conductive region of a respective one of the ground planes 164, 166, 168, 170, 172, 174 to facilitate signal transmission. The via 154 may be arranged in differential signal pairs that are placed in electrical communication with respective first and second sets of electrical differential signal traces that route electrical signals along the PCB 100. It is noted that only a portion of the signal vias, ground vias and/or signal traces are shown in FIG. 1 for ease of illustration. Further, while via 154 is identified as being configured as a signal via and via 157 is identified as being configured as a ground via, vias 154, 157 may be any type of via, whether signal, ground, or otherwise. The configuration, as discussed with Figure 1, is just one example and is not intended to be limiting.

According to some examples, planes, such as the metal planes, may include an anti-pad surrounding the loading pad formed on the respective plane. Anti-pads 155a-e may be formed adjacent to the loading pads 153a-e. The anti-pads 155a-e may be configured to circumscribe, encompass or surround the loading pads 153a-e. The anti-pads 155a-e may include nonconductive materials, such as insulating materials, to electrically insulate the loading pads 153 from other portions of PCB 100. In some examples, the anti-pads 155a-e may extend through the vertical height of at least some or all the dielectric layers 102-112 of PCB 100 to electrically isolate the loading pads 153a-e and the signal via 154 from the dielectric layers 104, 106, 108, 110, 112, 114, 116. In one example, the anti-pads 155a-e electrically isolate a respective signal via 154 from ground planes 164, 166, 168, 170, 172.

In one example, the anti-pads 155a-e can be defined by a respective void that allows the respective loading pads 153a-e to be disposed therein. The void can contain air or any suitable alternative dielectric or electrically insulative material. As a result, the anti-pads 155a-e can prevent the electrically conductive material of the loading pads 153a-e from being placed in physical contact or otherwise from being placed in electrical communication with the electrically conductive surface of the respective planes or signal planes. According to some examples, the anti-pad 155a-e may be surrounded by the conductive material from the loading pads 153a-e.

The loading pads 153a-e may have an area that extends along a plane defined by the respective ground plane 164, 166, 168, 170, 172. For example, the loading pads 153a-e may generally extend in a horizontal direction along the respective ground plane 164, 166, 168, 170, 172. According to some examples, ground planes 164, 166, 168, 170, 172 may be substantially perpendicular to a vertical surface in the transverse direction. Thus, the loading pads 153a-e may generally extend along a lateral direction L1, L2, relative to where the signal via 154 is located. In one example, the loading pads 153a-e may have an area between about 100 square mils (0.0001 square inches) and about 1000 square mils (0.001 square inches).

In one embodiment, the signal via 154 may be formed through the loading pads 153a-e, 165a-d and terminated on a via capture pad 197 formed on the signal plane 174. A signal trace 174 may be connected to the via capture pad 197 to facilitate signal transmission to other portions and structures of the PCB 100.

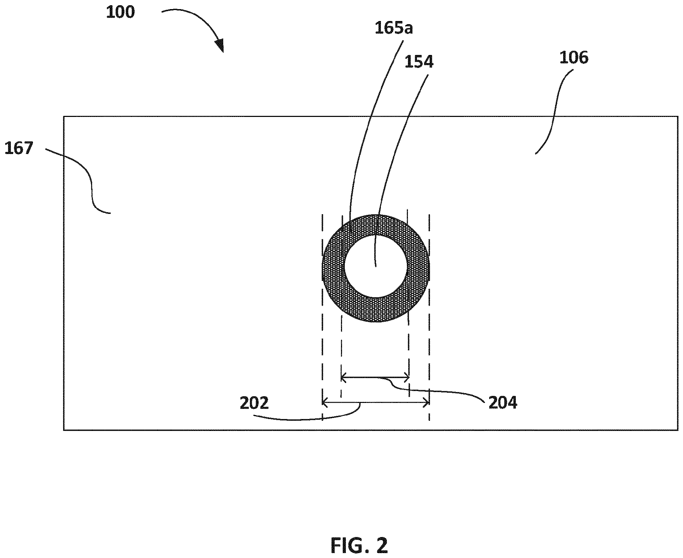

FIG.2 depicts a top view of a portion of the PCB 100 cutting along the axis A- A' depicted in FIG. 1. The loading pad 165a may be formed on the plane 180 between dielectric layer 103 and dielectric layer 104. Loading pad 165a may circumscribe the signal via 154. The signal via 154 may have a diameter in a range between about 4 mils (0.004 inches) and about 30 mils (0.03 inches). The loading pad 165a, and other loading pads, such as loading pads 165b-d, may have a diameter in a range between about 5 mils (0.005 inches) and about 50 mils (0.05 inches). It is noted that the sizes and dimensions of the loading pad 165a and the signal via 154 may be varied based on the sizes and dimensions of the electronic components mounted and soldered on the PCB for different electrical performance requirements. In one example, the dimensions, materials, and the configurations of the loading pads 165a-d may be configured to be similar or the same as the loading pads 153a-e, just with different locations where they are formed. For example, loading pads 165a-d may be formed on the plane 180, 182, 184, 186 between adjacent dielectric layers in direct contact with one another whereas loading pads 153a-e may be formed on the plane 164, 166, 168, 170, 172, which may be ground planes, signal planes, or another conductive plane defined between adjacent dielectric layers.

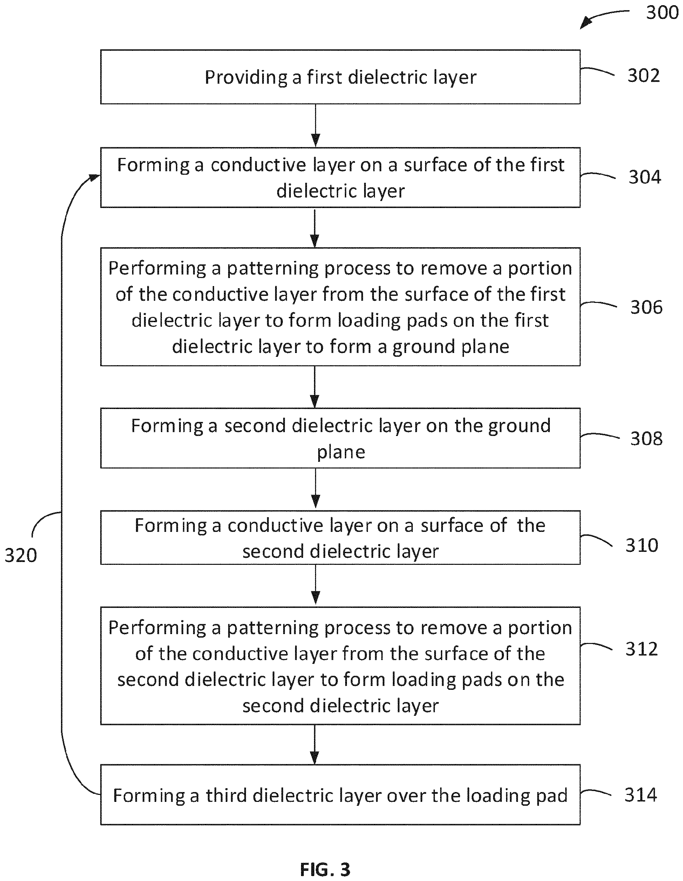

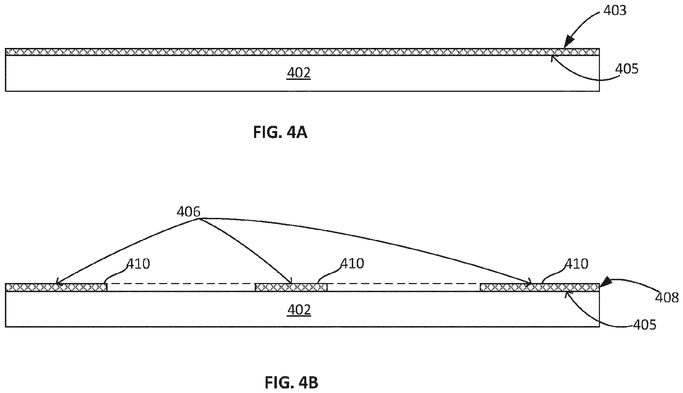

FIG. 3 depicts a flow chart for manufacturing loading pads 153a-e, 165a-d formed around the signal via 154 in accordance with aspects of the disclosure. FIGS. 4A-4I depicts cross-sectional view of manufacturing the loading pads 153a-e, 165a-d formed around the signal via 154 during different manufacturing stages of FIG. 3. Such method may be performed using suitable manufacturing processes, including depositing, etching, lithography, polishing, soldering, or any other suitable techniques. It should be understood that the operations involved in the following methods need not be performed in the precise order described. Rather, various operations may be handled in a different order or simultaneously, and operations may be added or omitted.

Referring to FIG. 3, in block 302, a first dielectric layer 402 is provided. The first dielectric layer 402, as shown in FIG. 4A, may be similar to any of the dielectric layers 102-112 described above with reference to FIG. 1. The first dielectric layer 402 may be formed on a substrate to form a PCB for advanced three dimensional electronic component packaging.

In block 304, a conductive layer 403 may be formed on a surface 405 of the first dielectric layer 402, as shown in FIG. 4A. The conductive layer 403 may be aluminum foils, copper foils, any suitable alloys or conductive materials for forming loading pads, signal trace lines and other conductive features in a PCB.

In block 306, a patterning process is performed to remove one or more portions of the conductive layer 403, as shown in FIG. 4B. Removing the one or more portions of the conductive layer 403 may forma plurality of conductive features 406. The conductive features 406 may be, for example, loading pads 410. According to some examples, the conductive features 406 may define a plane 408 that may be utilized as a signal plane, a power plane, or a ground plane to facilitate signal transmission. In the example depicted in FIG. 4B, the plane 408 defined by the conductive features 406 is a ground plane. The plane 408 may be substantially parallel to the surface 405 of the first dielectric layer 402. The loading pads 410 may be formed on or within plane 408.

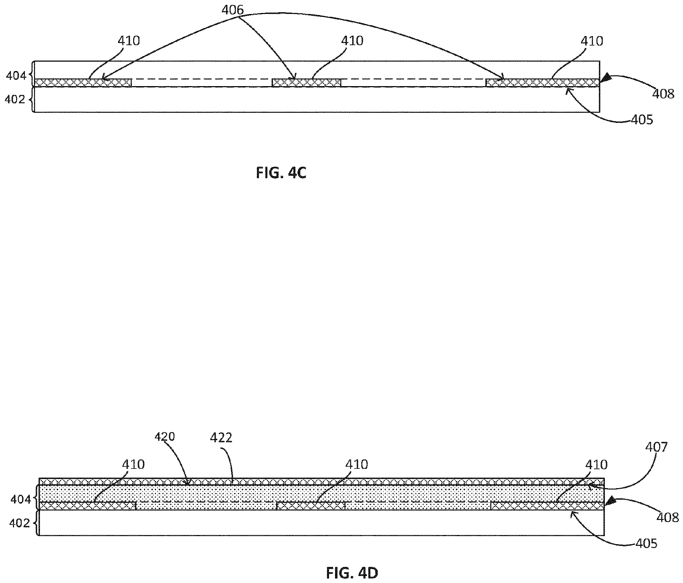

In block 308, a second dielectric layer 404 may be formed on the first dielectric layer 402, as shown in FIG. 4C. The second dielectric layer 404 may be similar to the dielectric layers 102-112 described above with reference to FIG. 1. The second dielectric layer 404 may be formed adjacent to the first dielectric layer 402. Ground plane 406 may extend between the interface of the first and second dielectric layers 402, 404. According to some examples, at least a portion of the first dielectric layer 402 may be in direct contact with the second dielectric layer 404. For example, the first dielectric layer 402 may be in direct contact with the second dielectric layer 404 in locations where the one or more portions of the conductive layer 403 have been removed.

In block 310, another conductive layer 422 may be formed on a surface 420 of the second dielectric layer 404, as shown in FIG. 4D. Similar to the conductive layer 403, discussed above, the conductive layer 422 may be aluminum foils, copper foils, any suitable alloys or conductive materials for forming loading pads, signal trace lines and other conductive features in a PCB.

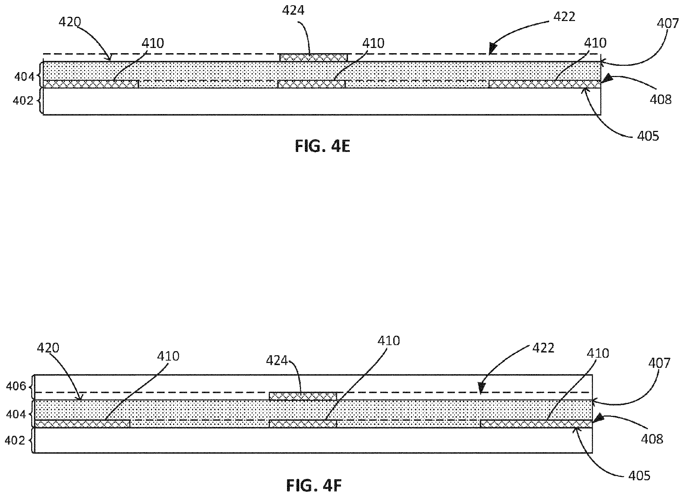

In block 312, a patterning process may be performed to remove a portion of the conductive layer 422, as shown in FIG. 4E. The portions of conductive layer 422 that remain may form one or more loading pad 424 on a surface 420 of the second dielectric layer 404. It is noted that at this stage, no other conductive features, such as trace lines, are formed on the surface 420 of the second dielectric layer 404. The loading pad 424 formed on the surface 420 of the second dielectric layer 404 may be similar to the loading pads 165a-d formed on the planes 180, 182, 184, 186, described above with reference to FIG. 1, between respective dielectric layers that are in direct contact with another dielectric layer, without a conductive plane extending therebetween.

In block 314, a deposition process may be performed to form a third dielectric layer 406, as shown in FIG. 4F. The second dielectric layer 404 may be in direct contact with the third dielectric layer 406, without a conductive plane, such as a metal plane, extending therebetween. Thus, the loading pad 424 may be formed on surface 420, corresponding to a plane, between the second dielectric layer 404 so that the loading pad 424 and the third dielectric layer 406. According to some examples, the surface 420 may correspond to a plane defined by the interface of the second dielectric layer 404 and third dielectric layer 406. Loading pad 424, as shown in Figure 4F, is located on a plane or a surface of a dielectric layer that does not have other conductive features, such as trace lines or other signal/ground transmission lines, formed thereon. According to some examples, forming loading pad 424 on the surface 424, or plane, between the second dielectric layer 404 and the third dielectric layer 406 may assist in managing the impedance and reduce likelihood of signal distortion.

As both loading pads 410, 424 and loading pad 410 are formed from the conductive features 151, which are copper foils, aluminum foils, or other suitable conductive materials, the loading pads 410, 424 may also be formed from copper foils, aluminum foils, or other suitable conductive materials.

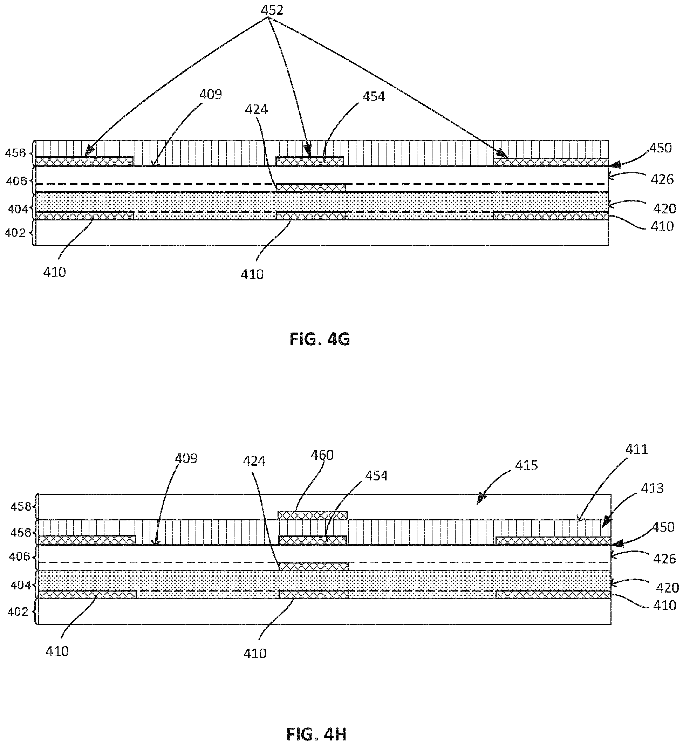

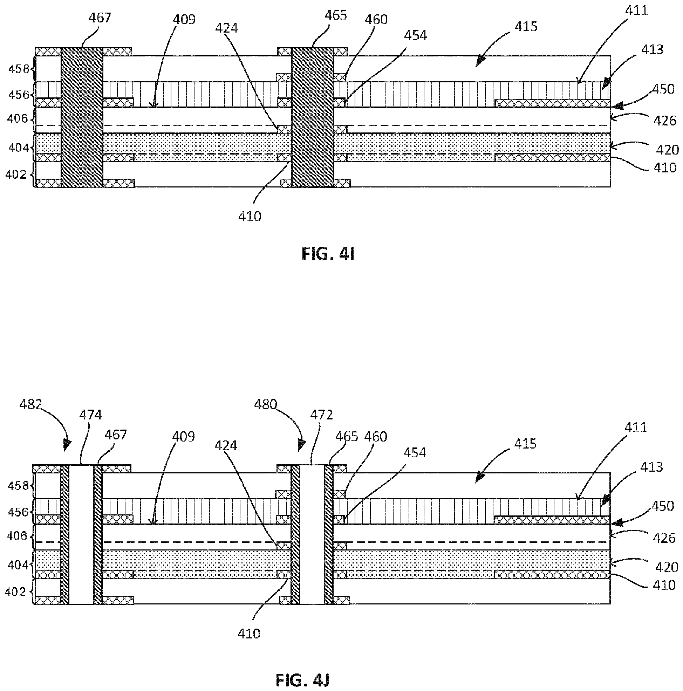

After the forming the third dielectric layer 406 such that loading pad 424 is formed between the second dielectric layer 404 and third dielectric layer 406, block 304 to block 314 may be repeatedly performed, as indicated by the loop 320, to repeatedly form different groups of the loading pads 410, 424 between adjacent dielectric layers that are in direct contact with each other and/or on a metal plane between adjacent dielectric layers. For example, as depicted in FIG. 4G, another ground plane 450 may be defined on a top surface 409 of the third dielectric layer 406 having conductive features 452. Conductive features 452 may be formed on the ground plane 450. The conductive features 452 may include one or more loading pads 454. According to some examples, a fourth dielectric layer 456 may be formed as part of the stack of dielectric layers. Subsequently, another loading pad 460 may be formed on a top surface 411 of the fourth dielectric layer 456, as shown in FIG. 4H. A fifth dielectric layer 458 may be formed. After desired numbers of the dielectric layers are formed for the PCB, a laser, drill or other suitable mechanical process may be used to form vias 465, 467, penetrating through the loading pads 410, 424, 454, 460, as shown in FIG. 4I. Once the vias 465, 467 are formed, the vias 465, 467 may be filled with a conductive material 472, 474, as shown in FIG. 4J. The filled vias 465, 467 may form a signal via 480 and a ground via 482, respectively.

It is noted that the via 480 may be configured as a ground via while the via 482 may be configured as a signal via to meet different electrical performance requirement. Thus, in this example, the loading pads 460, 424 may be formed adjacent to the ground via 482 instead of a signal via. It is noted that the loading pads 460, 424 may be formed adjacent to the ground vias or signal vias or both based on different electrical performance requirements or design layout configurations. It is noted that the anti-pads are eliminated and are not shown in FIG. 4A-4J for ease of illustration.

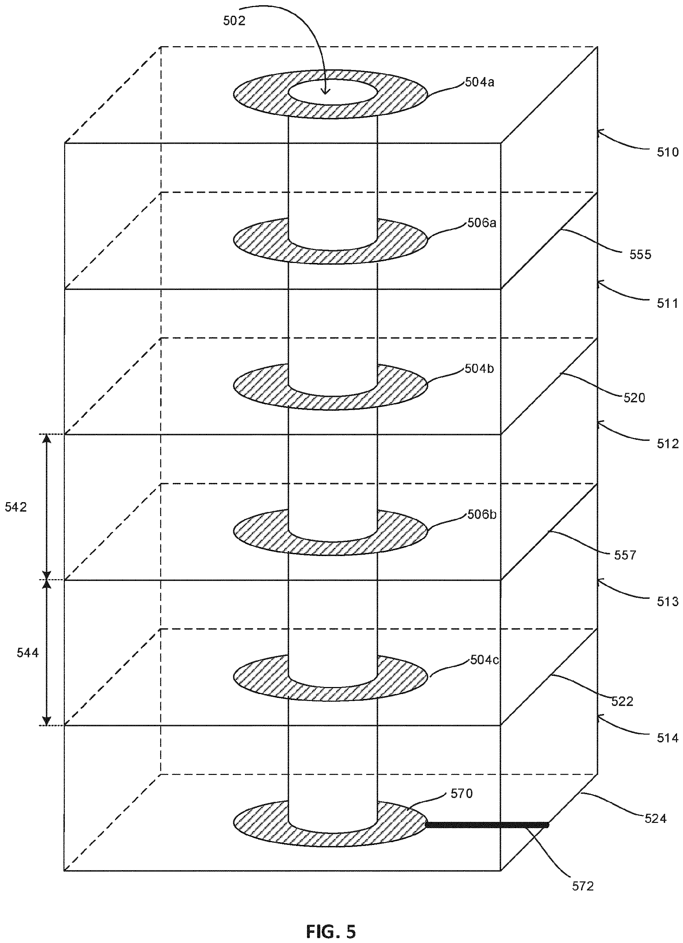

FIG. 5 depicts a perspective view of a plurality of loading pads, including loading pads 504a-c and loading pads 506a-b. Loading pads 504a-c may be loading pads that are formed on a plane between adjacent dielectric layers that are in direct contact with each other, while loading pads 506a-b may be loading pads that are formed on a metal layer that extends between adjacent loading pads. Loading pads 504a-c and loading pads 506a-b, and a stack of dielectric layers 508, 510, 512 may be part of a PCB. A signal via 502 may be formed through the stack of the dielectric layers 508, 510, 512. The signal via 502 may be circumscribed by the loading pads 504a-c located on ground planes 520, 522 or a signal plane 524. The signal via 502 is also circumscribed by the loading pads 506a-b formed on a plane between the dielectric layers 508, 510, 512 that are in direct contact with one another. The loading pads 504a-c may be vertically aligned with the loading pads 506a-b. Accordingly, in some examples, loading pads 504a-c and loading pads 506a-b may be concentrically formed around the signal via 502.

The loading pads 506a, 506b may be formed on respective planes 555, 557. The planes 555, 557 may be formed by the interface between respective dielectric layers 510-514 that are in direct contact with one another. For example, plane 555 may be formed by the interface between dielectric layer 510 and dielectric layer 511. According to some examples, planes 555, 557 may be spaced apart from the ground planes 520, 522 and/or signal planes 524 defined at the interface between the dielectric layers having a conductive plane extending therebetween.

According to some examples, each dielectric layer 510-514 may have a vertical distance. For example, dielectric layer 512 may have a vertical distance 542 and dielectric layer 513 may have a vertical distance 544. The vertical distances 542, 544 may be, in some examples, substantially equal. In some examples, the vertical distance 542 may be greater than the vertical distance 544, or vice versa. While the vertical distances of the dielectric layers 510-514 are shown as substantially equal, the vertical distances of each dielectric layer may be different, some of the dielectric layers 510-513 may have a vertical distance that is substantially the same, or a combination thereof. Accordingly, the vertical distances 542, 544, as shown, is just one example and is not intended to be limiting.

According to some examples, the signal via 502 may be formed through the stack of the dielectric layers 508, 510, 512 and terminated on a via capture pad 570 formed on the signal plane 524. A signal trace line 572 may be coupled to the via capture pad 570 to facilitate signal transmission to other conductive features and/or electronic devices, electric components, or other suitable structures formed in the PCB.

Thus, a printed circuit board (PCB) for three-dimensional (3D) packaging that may facilitate packaging multiple electronic components therein is provided. The PCB may include one or more loading pads formed around signal vias formed on or in the body of each or selected dielectric layers of the PCB. Thus, the loading pads formed around the signal vias, or optionally some ground vias, may reduce impedance discontinuity and thus reduce the likelihood of signal distortion.

Although the technology herein has been described with reference to particular examples, it is to be understood that these examples are merely illustrative of the principles and applications of the present technology. It is therefore to be understood that numerous modifications may be made and that other arrangements may be devised without departing from the spirit and scope of the present technology as defined by the appended claims.

## Claims

1. A printed circuit board (PCB), comprising:
a first dielectric layer;
a second dielectric layer formed adjacent to the first dielectric layer;
a first plane defined by an interface between the first and the second dielectric layers; and
at least one first loading pad formed on the first plane.

2. The PCB of claim 1, wherein the first plane includes a conductive layer, and wherein an antipad separates the first loading pad from the conductive layer.

3. The PCB of claim 2, wherein the antipad is a void in the conductive layer surrounding the first loading pad; and/or
wherein the antipad is a non-conductive material laterally separating the loading pad from the conductive layer.

4. The PCB of claim 2 or 3, wherein the conductive layer comprises a layer of patterned metal; and/or
wherein the conductive plane is a ground plane, a signal plane, or a power plane.

5. The PCB of one of claims 1 to 4, wherein the first and second dielectric layers are in direct contact with one another; and/or
wherein the first plane is devoid of metal except for the first loading pad.

6. The PCB of one of claims 1 to 5, further comprising:
a third dielectric layer vertically adjacent the second dielectric layer; and
a conductive plane extending between the second and third dielectric layers.

7. The PCB of claim 6, further comprising at least one second loading pad formed on the conductive plane.

8. The PCB of claim 7, wherein the at least one second loading pad is vertically aligned with the at least one first loading pad; and/or
wherein the at least one second loading pad is formed from aluminum foil or copper foil.

9. The PCB of claim 7 or 8, further comprising a via extending through the at least one first loading pad, the at least one second loading pad, the first dielectric layer, the second dielectric layer, and the third dielectric layer.

10. The PCB of claim 9, wherein the via is a signal via or a ground via.

11. A printed circuit board (PCB), comprising:
a stack of multiple dielectric layers;
conductive features formed at an interface between each of the dielectric layers, wherein at least a first subset of the conductive features are formed on a conductive plane extending between adjacent dielectric layers, and wherein at least a second subset of the conductive features are formed on a plane defined by an interface between adjacent dielectric layers in direct contact; and
a via formed through the one or more loading pads and the stack of multiple dielectric layers.

12. The PCB of claim 11, wherein the via is a signal via or a ground via; and/or
wherein the conductive features include one or more loading pads; and/or
wherein the conductive plane is at least one of a ground plane, a signal plane, or a power plane.

13. The PCB of claim 11 or 12, further comprising an anti-pad circumscribed around each of the first subset of conductive features.

14. A method for forming a PCB, comprising:
forming a first dielectric layer;
forming a first conductive layer on a surface of the first dielectric layer;
removing at least a portion of the first conductive layer; and
forming a second dielectric layer adjacent to at least a portion of the first dielectric layer.

15. The method of claim 14, wherein removing the at last a portion of the first conductive layer forms one or more loading pads.
